# EUROPEAN PATENT SPECIFICATION

(11) **EP 4 235 805 B1**
(45) Date of publication and mention of the grant of the patent: **29.10.2025**
(21) Application number: 22172642.5
(22) Date of filing: 10.05.2022
(51) Int. Cl.: H10F 71/00, H10F 77/20, H10F 77/30

(54) **SOLAR CELL AND METHOD FOR PREPARING THE SAME**
SOLARZELLE UND VERFAHREN ZUM HERSTELLEN DERSELBEN
CELLULE SOLAIRE ET SON PROCÉDÉ DE FABRICATION

(30) Priority: 25.02.2022 CN 202210174806
(43) Date of publication of application: 30.08.2023
(73) Proprietor: Zhejiang Jinko Solar Co., Ltd., Haining, Zhejiang (CN)
(72) Inventor: JIN, Jingsheng, Zhejiang (CN); ZHANG, Bike, Zhejiang (CN); CHU, Hong ao, Zhejiang (CN); ZHANG, Xinyu, Zhejiang (CN)
(74) Representative: Novagraaf International SA

(56) References cited:
- CN-A- 109 713 065
- CN-U- 214 254 436
- KR-A- 20160 064 702

## Description

### TECHNICAL FIELD

Embodiments of the present disclosure relate to the field of solar cells, in particular to a solar cell, a method for preparing the solar cell, and a photovoltaic module.

### BACKGROUND

A solar cell has a desirable photoelectric conversion capability. In order to suppress the recombination of carriers on a substrate surface and enhance the passivation effect on a substrate in the solar cell, a tunneling oxide layer and a doped conductive layer are generally prepared on the substrate surface. Among them, the tunneling oxide layer has better chemical passivation effect, and the doped conductive layer has better field passivation effect. In addition, in order to transport and collect photogenerated carriers generated by the solar cell, an electrode is further prepared on a part of the substrate surface. Document CN 109 713 065 A discloses a passivated solar cell with a printed metal electrode including an N-type crystalline silicon substrate, a tunnelling oxide layer, an n+ doped polysilicon layer, a back passivation anti-reflection film, and an n+ metal electrode, where the n+ doped polysilicon layer includes a first polysilicon region and a second polysilicon region. A doped polysilicon tail layer comprising a first tail region and a second tail region is formed on one side of the N-type crystalline silicon substrate close to the n+ doped polysilicon layer. The n+ metal electrode is H-shaped.

However, the solar cell prepared currently has a problem of high series resistance.

### SUMMARY

The present invention is set out in the appended set of claims.

### BRIEF DESCRIPTION OF THE DRAWINGS

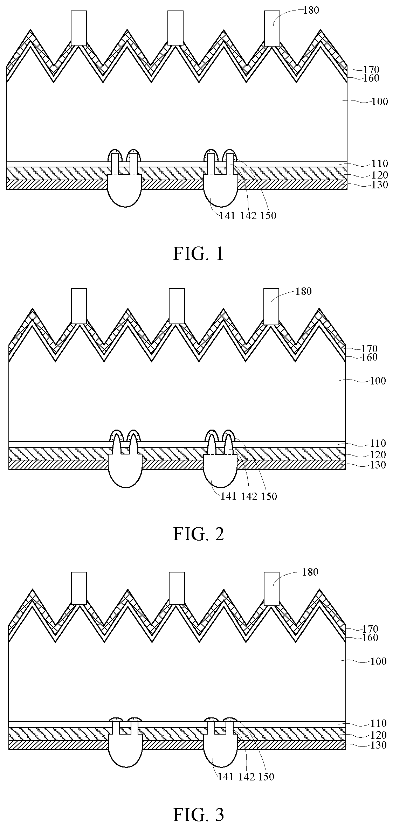

The following examples corresponding to FIG. 1 and FIG. 3 are not according to the invention and are present for illustration purposes only. One or more embodiments are described as examples with reference to the corresponding figures in the accompanying drawings, and the exemplary description does not constitute a limitation to the embodiments. The figures in the accompanying drawings do not constitute a proportion limitation unless otherwise stated.
FIG. 1 is not part of the present invention and is a schematic structural view of a solar cell;
FIG. 2 is another schematic structural view of a solar cell provided by an embodiment of the present disclosure;
FIG. 3 is not part of the present invention and is yet another schematic structural view of a solar cell;
FIG. 4 is a schematic structural view of a photovoltaic module provided according to an embodiment of the present disclosure;
FIG. 5 is a schematic structural view corresponding to an operation of providing a substrate in a method for preparing a solar cell provided according to another embodiment of the present disclosure;
FIG. 6 is a schematic structural view corresponding to an operation of forming an emitter in a method for preparing a solar cell provided according to another embodiment of the present disclosure;
FIG. 7 is a schematic structural view corresponding to an operation of forming a tunnelling oxide layer and doped conductive layer in a method for preparing a solar cell provided according to another embodiment of the present disclosure;
FIG. 8 is a schematic structural view corresponding to an operation of forming an anti-reflection layer in a method for preparing a solar cell provided according to another embodiment of the present disclosure;
FIG. 9 is a schematic structural view corresponding to an operation of forming a first passivation layer in a method for preparing a solar cell provided according to another embodiment of the present disclosure;
FIG. 10 is not part of the present invention and is a schematic structural view corresponding to an operation of forming a laser-treated region in a method for preparing a solar cell; and
FIG. 11 is another schematic structural view corresponding to an operation of forming a laser-treated region in a method for preparing a solar cell provided according to another embodiment of the present disclosure.

### DETAILED DESCRIPTION

It can be known from the background art that there is currently a problem of high series resistance in the solar cell.

The analysis found that one of the reasons for the high series resistance in the solar cell is, when currently preparing a solar cell, a tunneling oxide layer and a doped conductive layer are prepared on a backside surface of a substrate. In addition, a metal electrode is further prepared on a surface of the substrate, and the metal electrode is in contact with the doped conductive layer, but does not penetrate through the tunneling oxide layer, so as to maintain a desirable passivation effect of the tunneling oxide layer. However, the existence of the tunneling oxide layer limits the transport of carriers done by the metal electrode, resulting in a low carrier transport capability, thereby increasing the series resistance of the solar cell. The current research believes that the mechanism of carriers passing through the tunneling oxide layer follows the "pinhole theory", that is, when the thickness of the tunneling oxide layer exceeds a certain threshold, the possibility of carrier tunneling will be greatly reduced. In this case, the carriers are mainly transported through "pinholes". When the number of "pinholes" in the tunneling oxide layer is too small, the carrier transport will be limited; while the number of "pinholes" is excessive, it indicates that there are too many defects in the tunneling oxide layer, resulting in a decrease in the chemical passivation effect of the tunneling oxide layer. Therefore, how to reduce the series resistance of the solar cell while maintaining a desirable passivation effect of the solar cell is an urgent problem to be solved.

The embodiments of the present disclosure provide a solar cell, which includes a tunnelling oxide layer, a doped conductive layer and a first passivation layer that are provided on a first surface located at the substrate sequentially in a direction away from the substrate; a first metal electrode and a second metal electrode, where the first metal electrode penetrates through the first passivation layer to be electrically connected to the doped conductive layer, the second metal electrode is connected to a surface of the first metal electrode facing toward the substrate, the second metal electrode penetrates through the tunnelling oxide layer to be in contact with the substrate, so that the transport of carriers done by the second metal electrode is not limited by the tunneling oxide layer, which has a higher transport efficiency. In addition, the first metal electrode does not penetrate through the tunneling oxide layer, so that the tunneling oxide layer maintains better passivation effect, and the width of the second metal electrode is smaller than the width of the first metal electrode, that is, less of the second metal electrode are provided to penetrate through the tunneling oxide layer, so that the recombination loss at the second metal electrode is not greatly increased. A local doped region is further provided, the local doped region is located in the substrate, and covers the second metal electrode located in the substrate; the local doped region and the substrate have doping elements of a same conductivity type, and a doping concentration of the local doped region is greater than a doping concentration of the substrate. The doping concentration of the local doped region is greater than the doping concentration of the substrate, so as to form a heavily doped region. In this way, the heavily doped region forms a high and low junction with the substrate, which on the one hand has a better interface passivation effect, to reduce the recombination of carriers. On the other hand, the local doped region forms an ohmic contact with the second metal electrode, which reduces the series resistance of the solar cell, thereby improving the carrier transport capability while keeping a desirable passivation effect.

The embodiments of the present disclosure will be described in detail below with reference to the accompanying drawings. However, those skilled in the art may appreciate that, in the various embodiments of the present disclosure, numerous technical details are set forth in order to provide the reader with a better understanding of the present disclosure. However, the technical solutions claimed in the present disclosure may be implemented without these technical details and various changes and modifications based on the following embodiments.

FIG. 1 is a schematic structural view of a solar cell.

Referring to FIG. 1, the solar cell includes: a substrate 100; a tunnelling oxide layer 110, a doped conductive layer 120 and a first passivation layer 130 that are provided on a first surface located at the substrate 100 sequentially in a direction away from the substrate 100; a first metal electrode 141 and a second metal electrode 142, where the first metal electrode 141 penetrates through the first passivation layer 130 to be electrically connected to the doped conductive layer 120, the second metal electrode 142 is connected to a surface of the first metal electrode 141 facing toward the substrate 100, the second metal electrode 142 penetrates through the tunnelling oxide layer 110 to be in contact with the substrate 100, and a width of the second metal electrode 142 is smaller than a width of the first metal electrode 141; a local doped region 150, where the local doped region 150 is located in the substrate 100, and covers the second metal electrode 142 located in the substrate 100; the local doped region 150 and the substrate 100 have doping elements of a same conductivity type, and a doping concentration of the local doped region 150 is greater than a doping concentration of the substrate 100.

The substrate 100 is configured to receive incident light and generate photogenerated carriers. In some embodiments, the substrate 100 may be embodied as a silicon substrate, and the material of the silicon substrate may include at least one of monocrystalline silicon, polycrystalline silicon, amorphous silicon, or microcrystalline silicon. In other embodiments, the material of the substrate 100 may also be at least one of simple substance carbon, organic material, or multicomponent compound, where the multicomponent compound includes gallium arsenide, cadmium telluride, copper indium selenide, and the like.

In some embodiments, the solar cell is a tunnel oxide passivated contact (TOPCON) cell, the substrate 100 further includes a second surface opposite to the first surface, the first surface and the second surface of the substrate 100 are both configured to receive incident light or reflected light. In some embodiments, the second surface of the substrate 100 may be configured as a pyramid textured surface, so that the reflectivity of the second surface of the substrate 100 to incident light is lower, resulting in a higher absorption and utilization rate of light. The first surface of the substrate 100 may be configured as a non-pyramid textured surface, such as a stacked step topography, so that the tunneling oxide layer 110 on the first surface of the substrate 100 has high density and uniformity, which causes the tunneling oxide layer 110 has a desirable passivation effect on the first surface of the substrate 100. In some embodiments, the first surface may be a backside surface of the substrate 100, and the second surface may be a frontside surface of the substrate 100. In other embodiments, the first surface may also be the frontside surface of the substrate 100, and the second surface may be the backside surface of the substrate 100.

In some embodiments, the substrate 100 is an N-type semiconductor substrate, that is, the substrate 100 is doped with N-type doping ions, where the N-type doping ions may be any one of phosphorus ions, arsenic ions, or antimony ions. The second surface of the substrate 100 has an emitter 160. The emitter 160 may be a P-type doped layer doped with P-type ions. The emitter 160 and the substrate 100 form a PN junction. In some embodiments, the emitter 160 may be obtained by doping a surface layer of the substrate 100 with P-type ions, and the doped part of the substrate 100 is converted into the emitter 160. Specifically, in some embodiments, the P-type ions may be boron ions.

The tunneling oxide layer 110 and the doped conductive layer 120 are configured as passivation contact layers, where the tunneling oxide layer 110 is configured to realize the interface passivation of the first surface of the substrate 100, to achieve chemical passivation. Specifically, since there are interface state defects at the interface of the substrate 100, the interface state density of the substrate 100 is relatively large, and the increase of the interface state density will promote the recombination of photogenerated carriers, thereby reducing the fill factor and conversion efficiency of the solar cell. Therefore, the tunneling oxide layer 110 is provided on the first surface of the substrate 100, so that the tunneling oxide layer 110 has the effect of chemical passivation on the first surface of the substrate 100. Specifically, by saturating dangling bond on the surface of the substate 100, the interface defect state density of the surface of the substrate 100 is reduced, thereby reducing the recombination center on the surface of the substrate 100 to reduce the carrier recombination rate.

Although the tunneling oxide layer 110 has a desirable chemical passivation effect, the existence of the tunneling oxide layer 110 limits the transport of carriers by the first metal electrode 141, especially after the thickness of the tunneling oxide layer 110 is increased, the transport of carriers by the first metal electrode 141 will be further limited. Based on this point, in the embodiments of the present disclosure, the second metal electrode 142 is provided to penetrate through the tunneling oxide layer 110, so that the transport of carriers by the second metal electrode 142 is not limited by the tunneling oxide layer 110, thereby reducing the series resistance of the solar cell and improving the conversion efficiency of the solar cell. On the other hand, since the transport of carriers by the second metal electrode 142 is not limited by the tunneling oxide layer 110, the thickness limit on the tunneling oxide layer 110 can be reduced, so that the thickness of the tunneling oxide layer 110 can be reasonably adjusted while not compromising the capability of the second metal electrode 142 transporting carriers, so that the tunneling oxide layer 110 has a better chemical passivation effect, thereby further reducing the interface state density of the substrate 100 and improving the fill factor and conversion efficiency of the solar cell. Based on this point, in some embodiments, the thickness of the tunneling oxide layer 110 may range from 0.5 nm to 2.5 nm, for example, 1.5 nm. Specifically, in some embodiments, the material of the tunneling oxide layer 110 may be a dielectric material, such as silicon oxide.

The doped conductive layer 120 is configured to form a field passivation layer, where the field passivation is to form an electrostatic field at the interface of the substrate 100 directed to the inside of the substrate 100, so that minority carriers escape from the interface, thereby reducing the concentration of minority carriers, resulting in a lower recombination rate of carriers at the interface of the substrate 100, so that the open circuit voltage, short circuit current and filling factor of the solar cell are relatively larger, and the photoelectric conversion performance of the solar cell is improved. In some embodiments, the doped conductive layer 120 and the substrate 100 have doping elements of the same conductivity type, where the doped conductive layer 120 may be doped silicon, and the doped silicon may specifically be embodied as one or more of N-type doped polysilicon, N-type doped microcrystalline silicon or N-type doped amorphous silicon, the doped conductive layer 120 contains N-type doped ions, such as phosphorus ions, arsenic ions or antimony ions.

The first metal electrode 141 does not penetrate through the tunneling oxide layer 110 and is not electrically connected to the doped conductive layer 120. In this way, on the one hand, the first metal electrode 141 can perform carrier transport through the doped conductive layer 120, and on the other hand, since the first metal electrode 141 does not penetrate through the tunneling oxide layer 110, that is, the tunneling oxide layer 110 has high integrity, and therefore, a desirable passivation effect of the tunneling oxide layer 110 can be maintained. In addition, compared to the second metal electrode 142 as an electrode, which is provided to penetrate through the tunneling oxide layer 110, the first metal electrode 141 is electrically connected to the doped conductive layer 120, and the second metal electrode 142 penetrates through the tunneling oxide layer 110 and is in direct contact with the substrate 100, so that the first metal electrode 141 and the second metal electrode 142 both play the role of transporting carriers while maintaining the desirable passivation capability of the tunneling oxide layer 110. Therefore, the transport rate of carriers is faster, which greatly reduces the series resistance of the solar cell. It should be noted that, in some embodiments, the second metal electrode 142 may be in direct contact with the first metal electrode 141 to form an electrical connection. In other embodiments, the second metal electrode 142 may not be in direct contact with the first metal electrode 141, that is, the electrical connection may be formed by indirect connection, for example, the electrical connection may be formed by a conductive wire. The embodiments of the present disclosure do not limit the specific connection manner between the first metal electrode 141 and the second metal electrode 142, as long as the first metal electrode 141 and the second metal electrode 142 are electrically connected.

While providing the second metal electrode 142 to penetrate through the tunneling oxide layer 110 to improve the carrier transport efficiency, the effect of the second metal electrode 142 on the passivation capability of the tunneling oxide layer 110 needs to be considered, that is, not only the second metal electrode 142 needs to have a larger cross-sectional area to achieve a better carrier transport capability, thereby reducing the series resistance of the solar cell, but also the contact area between the tunneling oxide layer 110 and the substrate 100 needs to be larger, so that the tunneling oxide layer 110 can achieve a better chemical passivation effect on the first surface of the substrate 100. Based on the above considerations, in some embodiments, a ratio of the contact area between the second metal electrode 142 and the first metal electrode 141 to the cross-sectional area of the first metal electrode 141 may range from 1:16 to 2:3, for example, may be 1:2. Within this range, the recombination loss of the second metal electrode 142 in the tunneling oxide layer 110 is relatively small, and the carrier transport capability of the second metal electrode 142 is greatly improved, thereby reducing the series resistance of the solar cell and improving the photoelectric conversion efficiency of solar cell. It should be noted that the cross-sectional area of the first metal electrode 141 refers to a cross-sectional area in a direction parallel to the first surface of the substrate 100.

FIG. 2 is another schematic structural view of a solar cell provided according to an embodiment of the present disclosure. Referring to FIG. 2, the second metal electrode 142 includes multiple sub-electrodes provided in a spaced manner, and in a direction from the tunnelling oxide layer to the substrate, widths of the multiple sub-electrodes gradually decrease. Compared with the sub-electrodes with constant width, the gradually decreasing widths of the sub-electrodes makes the volume of the second metal electrode 142 in the tunneling oxide layer 110 smaller, thereby reducing damage to the tunneling oxide layer 110. And along the direction from the tunneling oxide layer 110 to the substrate 100, the multiple sub-electrodes located in the tunneling oxide layer 110 gradually decrease in cross-sectional area, so that the contact area between the tunneling oxide layer 110 and the first surface of the substrate 100 is larger. Therefore, while improving the carrier transport capability of the second metal electrode 142, the effect of the second metal electrode 142 on the passivation effect of the tunneling oxide layer 110 can be further weakened, which is beneficial to maintain the chemical passivation capability of the tunneling oxide layer 110. In addition, the second metal electrode 142 includes multiple sub-electrodes provided in a spaced manner, so that each of the multiple sub-electrodes is covered by the local doped region 150, compared with a case of providing only one second metal electrode 142 being covered by the local doped region 150, a case of providing multiple sub-electrodes being covered by the local doped region 150 greatly increases the contact area between the local doped region 150 and the second metal electrode 142, so that the interface passivation effect of the local doped region 150 on the second metal electrode 142 can be improved, and it is beneficial to further form an ohmic contact between the second metal electrode 142 and the local doped region 150, to reduce the series resistance of the solar cell.

In some embodiments, in the direction from the tunneling oxide layer 110 to the substrate 100, a ratio of the length of the second metal electrode 142 in the substrate 100 to the length of the second metal electrode 142 may range from 1:10 to 9:10, for example 2:3. Within this range, on the one hand, the length of the second metal electrode 142 in the substrate 100 can be longer, so that the contact area between the second metal electrode 142 and the local doped region 150 is larger, which causes the local doped region 150 to have a better interface passivation effect on the second metal electrode 142, to improve the performance of the solar cell, and it is also beneficial to further form an ohmic contact between the second metal electrode 142 and the local doped region 150, thereby reducing the series resistance of the solar cell. On the other hand, within this range, the length of the second metal electrode 142 will not be excessive, so that the material for forming the second metal electrode 142 can be saved, which is beneficial to control the cost.

FIG. 3 is another schematic structural view of a solar cell. Referring to FIG. 3, the second metal electrode 142 is flushed with the surface of the tunneling oxide layer 110 facing toward the substrate 100

In some embodiments, the material of the first metal electrode 141 and the second metal electrode 142 may be at least one of silver, aluminum, copper, tin, gold, lead or nickel.

Reference is continuously made to FIG. 1, the local doped region 150 is located in the substrate 100 and has doping ion of the same type as the substrate 100, where the doping ion concentration of the local doped region 150 is greater than the doping ion concentration of the substrate 100, so that the local doped region 150 forms a heavily doped region, and the heavily doped region forms a high-low junction with the substrate 100. Since the local doped region 150 is in contact with the second metal electrode 142, the local doped region 150 can passivate the interface between the second metal electrode 142 and the substrate 100, which reduces the recombination of carriers at the interface, thereby increasing the carrier concentration. In addition, the local doped region 150 also forms an ohmic contact with the second metal electrode 142, which further reduces the series resistance of the solar cell. Specifically, in some embodiments, when the substrate 100 is a N-type semiconductor substrate 100, the doping ions of the local doped region 150 may be any one of phosphorus ions, arsenic ions or antimony ions.

In some embodiments, a ratio of the doping concentration of the local doped region 150 to the doping concentration of the substrate 100 may range from 10000:1 to 200000:1. Within this range, a difference in doping concentration between the local doped region 150 and the substrate 100 is relatively large, so that a high-low junction can be formed, which is beneficial to reduce the recombination of carriers at the interface between the second metal electrode 142 and the substrate 100, thereby enhancing the capability for transporting the carriers. Moreover, within this range, an ohmic contact can also be formed between the local doped region 150 and the second metal electrode 142, so that the series resistance can be reduced, the solar cell has a larger open circuit voltage, and the photoelectric conversion efficiency of the solar cell can be improved. Specifically, in some embodiments, the doping concentration of the local doped region 150 may ranges from 1x10²⁰ atoms/cm³ to 2x10²¹ atoms/cm³, for example, 5x10²⁰ atoms/cm³.

In some embodiments, the substrate 100 may further include a first region 1 and a second region 2 that are arranged in the direction from the tunnelling oxide layer 110 to the substrate 100, a boundary line between the first region 1 and the second region 2 is flush with a top surface of the local doped region 150 away from the second metal electrode 142, where the doping concentration of the first region 1 is greater than that of the second region 2, and the doping concentration of the local doped region 150 is greater than the doping concentration of the first region 1. That is to say, the local doped region 150 is located in the first region 1. Therefore, the doping concentration of the local doped region 150 is greater than that of the first region 1, which is beneficial to form a concentration gradient from the local doped region 150 to the first region 1, thereby forming the high-low junction. Specifically, the doping ion type of the first region 1 is the same as the doping ion type of the second region 2, and the doping ion concentration of the first region 1 is greater than the doping ion concentration of the second region 2, that is, a concentration gradient of the doping ion with the same type is formed between the first region 1 and the second region 2 to form a backside electric field. The existence of the backside electric field can make the carriers generate a potential barrier effect, thereby reducing recombination of the carriers at the first surface of the substrate 100, so that the carriers are effectively collected to further reduce the series resistance of the solar cell. At the same time, the backside electric field can also improve the long-wave response of the solar cell and increase the short-circuit current and open-circuit voltage of the solar cell.

Reference is continuously made to FIG. 1, the first passivation layer 130 is located on a side of the doped conductive layer 120 away from the substrate 100 for enhancing the incident effect of incident light on the substrate 100, and for enhancing the passivation effect of the doped conductive layer 120 and tunneling oxide layer 110. The material of the first passivation layer 130 may be one or more of silicon oxide, aluminum oxide, silicon nitride, silicon oxynitride or silicon oxycarbonitride. Specifically, in some embodiments, the first passivation layer 130 may be embodied as a single-layer structure. In other embodiments, the first passivation layer 130 may also be embodied as a multi-layer structure.

In some embodiments, an anti-reflection layer 170 may further be included, and the anti-reflection layer 170 is provided on the second surface. The anti-reflection layer 170 plays a role of anti-reflection for incident light, that is, reducing the reflectivity of the substrate 100 for incident light. In this way, the substrate 100 can absorb more incident light rays, so that the utilization rate of sunlight is larger, and the photoelectric conversion performance of the solar cell is further improved.

In some embodiments, the anti-reflection layer 170 may be embodied as a silicon nitride layer, and the silicon nitride layer may include silicon nitride material, which has a higher refractive index, so that more incident light rays enter the substrate 100, and the utilization of incident light is increased. In addition, the silicon nitride material also has a desirable hydrogen passivation effect, so it can increase the carrier concentration on the backside of the substrate 100, suppress the carrier recombination, and improve the open circuit voltage, short circuit current and fill factor of the solar cell. In other embodiments, the anti-reflection layer 170 may also be configured as a multi-layered structure, for example, a stack-layer structure composed of one or more materials of silicon nitride, silicon oxide, or silicon oxynitride.

In some embodiments, the solar cell further includes a third metal electrode 180. The third metal electrode 180 is located on the second surface of the substrate 100, penetrates through the anti-reflection layer 170 to be electrically connected to the emitter 160.

In the solar cell provided according to the above embodiments, the first metal electrode 141 is provided to penetrate through the first passivation layer 130 to be electrically connected to the doped conductive layer 120, the second metal electrode 142 is connected to a surface of the first metal electrode 141 facing toward the substrate 100, the second metal electrode 142 penetrates through the tunnelling oxide layer 110 to be in contact with the substrate 100, so that the transport of carriers done by the second metal electrode 142 is not limited by the tunneling oxide layer 110, which has a higher transport efficiency. In addition, the first metal electrode 141 does not penetrate through the tunneling oxide layer 110, so that the tunneling oxide layer 110 maintains a better passivation effect. The local doped region 150 is further provided to be located in the substrate 100, and covers the second metal electrode 142 located in the substrate 100. The local doped region 150 and the substrate 100 have doping elements of a same conductivity type, and a doping concentration of the local doped region 150 is greater than a doping concentration of the substrate 100. The doping concentration of the local doped region 150 is greater than the doping concentration of the substrate 100, that is, a heavily doped region is formed, and the heavily doped region forms a high and low junction with the substrate 100, which on the one hand has a better interface passivation effect, to reduce the recombination of carriers. On the other hand, the local doped region 150 forms an ohmic contact with the second metal electrode 142, which reduces the series resistance of the solar cell, thereby improving the carrier transport capability while keeping a desirable passivation effect.

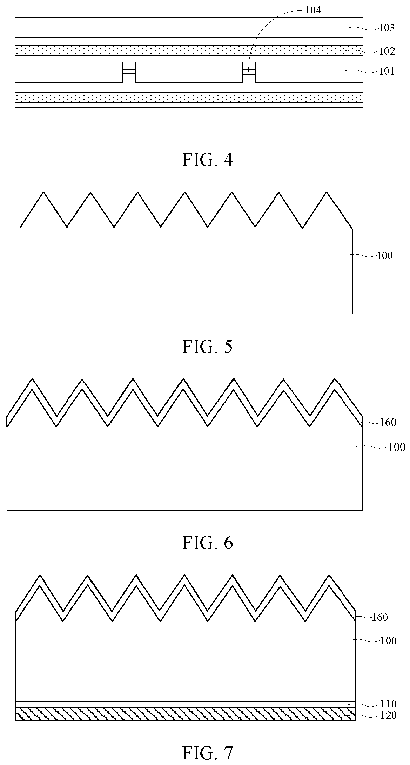

Accordingly, embodiments of the present disclosure further provide a photovoltaic module. Referring to FIG. 4, the photovoltaic module includes a cell string, where the cell string is formed by connecting multiple solar cells 101 with each other, each of the multiple solar cells 101 being a solar cell according to any one of the above embodiments; a package layer 102 configured to cover a surface of the cell string; a cover plate 103 configured to cover a surface of the package layer 102 away from the cell string. The solar cells 101 form multiple cell strings in a form of whole sheet or multiple separated sheets, and the multiple cell strings are electrically connected in a series and/or parallel manner.

Specifically, in some embodiments, the multiple cell strings can be electrically connected by conductive strips 104. The package layer 102 covers the frontside surface and backside surface of the solar cell 101. Specifically, the package layer 102 may be embodied as an organic package adhesive film, such as an ethylene-vinyl acetate copolymer (EVA) adhesive film, a polyethylene octene co-elastomer (POE) adhesive film or a polyethylene terephthalate (PET) adhesive film. In some embodiments, the cover plate 103 may be embodied as a cover plate 103 with a light-transmitting function, such as a glass cover plate, a plastic cover plate, or etc. Specifically, a surface of the cover plate 103 facing toward the package layer 102 may be a concave-convex surface, so as to increase the utilization rate of incident light. Referring to FIG. 1 to FIG. 4, in the embodiments of the present disclosure, since the first metal electrode 141 is provided to penetrate through the first passivation layer 130 to be electrically connected to the doped conductive layer 120, the second metal electrode 142 is connected to the surface of the first metal electrode 141 facing toward the substrate 100, the second metal electrode 142 penetrates through the tunneling oxide layer 110 to be in contact with the substrate 100, so that the transport of carriers done by the second metal electrode 142 is not limited by the tunneling oxide layer 110, which has a higher transport efficiency. In addition, the first metal electrode 141 does not penetrate through the tunneling oxide layer 110, so that the tunneling oxide layer 110 maintains a better passivation effect, so as to improve the photoelectric conversion efficiency of the solar cell, thereby improving the overall photoelectric conversion performance of the photovoltaic module.

Accordingly, another embodiment of the present disclosure further provides a method for preparing a solar cell, and the method for preparing a solar cell can form the solar cell provided according to the previous embodiment of the present disclosure. The method for preparing a solar cell provided according to another embodiment will be described in detail with reference to accompanying drawings.

FIG. 5 to FIG. 9 and FIG. 11 are schematic structural views corresponding to various operations in the method for preparing a solar cell provided according to another embodiment of the present disclosure.

FIG. 5 is a schematic structural view corresponding to an operation of providing a substrate in the method for preparing a solar cell provided according to another embodiment of the present disclosure. Referring to FIG. 5, a substrate 100 is provided.

The substrate 100 is configured to receive incident light and generate photogenerated carriers. In some embodiments, the substrate 100 may be embodied as a silicon substrate, and the material of the silicon substrate may include monocrystalline silicon, polycrystalline silicon, amorphous silicon, or microcrystalline silicon. In other embodiments, the material of the substrate 100 may also be simple substance carbon, organic material, or multicomponent compound, where the multicomponent compound includes gallium arsenide, cadmium telluride, copper indium selenide, and the like.

In some embodiments, the solar cell is a TOPCON cell, the substrate 100 further includes a second surface opposite to the first surface, the first surface may be embodied as a backside surface of the substrate 100, and the second surface may be embodied as a frontside surface of the substrate 100. In some embodiments, the second surface of the substrate 100 may be configured as a pyramid textured surface, so that the reflectivity of the second surface of the substrate 100 to incident light is lower, resulting in a higher absorption and utilization rate of light. In some embodiments, the substrate 100 is an N-type semiconductor substrate, that is, the substrate 100 is doped with N-type doping ions, and the N-type doping ions may be any one of phosphorus ions, arsenic ions, or antimony ions.

FIG. 6 is a schematic structural view corresponding to an operation of forming an emitter in a method for preparing a solar cell provided according to another embodiment of the present disclosure. Referring to FIG. 6, an emitter 160 is formed. In some embodiments, the substrate 100 is an N-type semiconductor The substrate, the emitter 160 may be embodied as a P-type emitter 160. Specifically, a specific process method for forming the emitter 160 is: performing boron diffusion treatment on the first surface of the substrate 100 to form the emitter 160, and the emitter 160 and the N-type substrate form a PN junction.

FIG. 7 is a schematic structural view corresponding to an operation of forming a tunneling oxide layer and a doping conductive layer in the method for preparing a solar cell provided according to another embodiment of the present disclosure. Referring to FIG. 7, a tunneling oxide layer 110 and a doped conductive layer 120 are sequentially formed on the first surface of the substrate 100 and in a direction away from the substrate 100.

The tunneling oxide layer 110 is configured to achieve interface passivation on the backside surface of the substrate 100. In some embodiments, the tunneling oxide layer 110 may be formed by a deposition process, such as a chemical vapor deposition process. In other embodiments, the tunneling oxide layer 110 may also be formed by an in-situ generation process, for example, a thermal oxidation process and a nitric acid passivation process are used to generate the tunneling oxide layer 110 in-situ on the substrate 100. Specifically, the material of the tunneling oxide layer 110 may be a dielectric material, such as silicon oxide.

The doped conductive layer 120 is configured to form field passivation. In some embodiments, the material of the doped conductive layer 120 may be doping silicon. Specifically, in some embodiments, the doped conductive layer 120 and the substrate 100 have doping elements of the same conductivity type. Doping silicon may include one or more of N-type doping polysilicon, N-type doping microcrystalline silicon or N-type doping amorphous silicon. In some embodiments, the doped conductive layer 120 may be formed by a deposition process. Specifically, intrinsic polysilicon may be deposited on the surface of the tunneling oxide layer 110 away from the substrate 100 to form a polysilicon layer, and ion implantation and source diffusion may be used to dope phosphorus ions, to form an N-type doped polysilicon layer, and the doped polysilicon layer serves as the doped conductive layer 120.

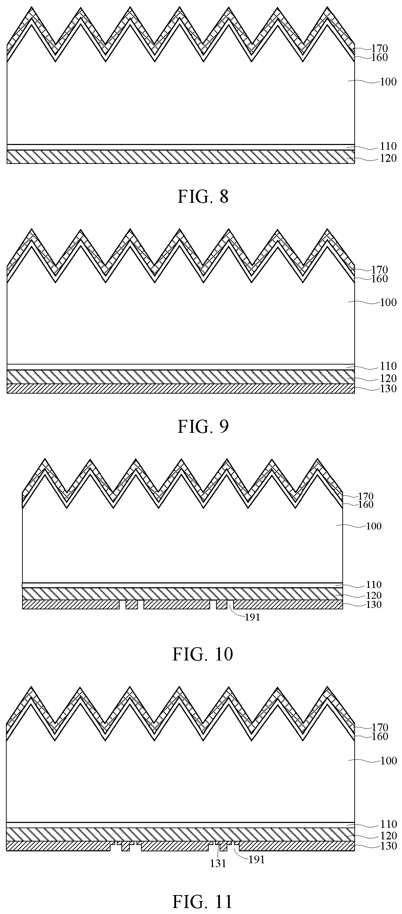

FIG. 8 is a schematic structural view corresponding to an operation of forming an anti-reflection layer in the method for preparing a solar cell provided according to another embodiment of the present disclosure. Referring to FIG. 8, an anti-reflection layer 170 is formed on the second surface of the substrate 100, in some embodiments, the anti-reflection layer 170 may be embodied as a silicon nitride layer, and the silicon nitride layer includes silicon nitride material. Specifically, in some embodiments, the anti-reflection layer 170 may be formed by using a plasma enhanced chemical vapor deposition (PECVD) method. Specifically, the process method for forming the anti-reflection layer 170 includes: silane gas and ammonia gas are introduced into a PECVD reaction chamber and ionized to form the anti-reflection layer 170 on the second surface of the substrate 100.

FIG. 9 is a schematic structural view corresponding to an operation of forming a first passivation layer in the method for preparing a solar cell provided according to another embodiment of the present disclosure. Referring to FIG. 9, a first passivation layer 130 is formed on the surface of the doped conductive layer 120 away from the substrate 100. In some embodiments, the material of the first passivation layer 130 may be one or more of silicon oxide, aluminum oxide, silicon nitride, silicon oxynitride or silicon oxycarbonitride. Specifically, in some embodiments, the first passivation layer 130 may be embodied as a single-layer structure. In other embodiments, the first passivation layer 130 may also be embodied as a multi-layer structure. Specifically, in some embodiments, the first passivation layer 130 may be formed by using a PECVD method.

FIG. 10 is a schematic structural view corresponding to an operation of forming a laser-treated region in a method for preparing a solar cell provided according to an example not being part of the present invention, and FIG. 11 is a schematic structural view corresponding to an operation of forming a laser-treated region in the method for preparing a solar cell provided according to another embodiment of the present disclosure.

Referring to FIG. 10, FIG. 11 and FIG. 1, the first metal electrode 141 and the second metal electrode 142 are formed, the first metal electrode 141 penetrates through the first passivation layer 130 to be electrically connected to the doped conductive layer 120, and the second metal electrode 142 is connected to a surface of the first metal electrode 141 facing toward the substrate 100, the second metal electrode 142 penetrates through the tunnelling oxide layer 110 to be in contact with the substrate 100, and a width of the second metal electrode 142 is smaller than a width of the first metal electrode 141. The local doped region 150 is formed in the substrate 100, and the local doped region 150 covers the second metal electrode 142 located in the substrate 100. The local doped region 150 and the substrate 100 have doping elements of the same conductivity type, and a doping concentration of the local doped region 150 is greater than a doping concentration of the substrate 100.

The first metal electrode 141 is provided to penetrate through the first passivation layer 130 to be electrically connected to the doped conductive layer 120, the second metal electrode 142 is connected to a surface of the first metal electrode 141 facing toward the substrate 100, so that the transport of carriers done by the second metal electrode 142 is not limited by the tunneling oxide layer 110, which has a higher transport efficiency. In addition, the first metal electrode 141 does not penetrate through the tunneling oxide layer 110, so that the tunneling oxide layer 110 maintains a better passivation effect.

Specifically, following operations are included in the method for forming the first metal electrode 141 and the second metal electrode 142.

Referring to FIGS. 10 and 11, a laser process is performed on a part of the first passivation layer 130 of the substrate 100 to form a laser-treated region 191. The laser-treated region 191 corresponds to a region where the second metal electrode is to be formed. In the first passivation layer 130, a region other than the laser-treated region 191 is defined as a flat region, the flat region includes a region where the first metal electrode is to be formed, and the laser-treated region 191 is located in the region where the first metal electrode is to be formed. Laser etching is performed on a part of the first passivation layer 130 by using a laser process, so that the thickness of the first passivation layer 130 corresponding to the formed laser-treated region 191 is smaller than the thickness of the first passivation layer 130 corresponding to the flat region. In view of this, when the first passivation layer 130 is subsequently metallized, the second metal electrode 142 formed on a surface of a part of the first passivation layer 130 with a smaller thickness can penetrate the tunneling oxide layer 110 to be in contact with the substrate 100, but when a part of the first passivation layer 130 corresponding to the region where the first metal electrode is to be formed is metallized, since there is a long distance between conductive paste and the tunneling oxide layer 110, the formed first metal electrode 141 will only be electrically connected to the doped conductive layer 120 without penetrating through the tunneling oxide layer 110. In addition, a part of the first passivation layer 130 is laser etched by using a laser process, which has simple process operations, and there is no need to remove the mask after a region where the second metal electrode is to be formed is prepared, so that the process operations are simplified, and the time required for the process is greatly saved. The laser-treated region 191 is located in the region where the first metal electrode is to be formed. Thus, when the conductive paste is subsequently printed on the laser-treated region 191 and the region where the first metal electrode is to be formed to form the first metal electrode 141 and the second metal electrode 142, the second metal electrode 142 is formed in contact with the first metal electrode 141, and the width of the first metal electrode 141 is larger than that of the second metal electrode 142.

Referring to FIG. 10, in an example not being part of the present invention, a method for laser processing a part of the first passivation layer 130 of the substrate 100 to form the laser-treated region 191 includes: laser etching the part of the first passivation layer 130 where the laser-treated region is to be formed by laser processing until a part of a surface of the doped conductive layer 120 is exposed, to form the laser-treated region 191. That is, the part of the first passivation layer 130 corresponding to the laser-treated region 191 is completely etched away by using a laser process, and a part of the surface of the doped conductive layer 120 is exposed as the laser-treated region 191. In this way, when the conductive paste is subsequently printed on the laser-treated region 191 to form the second metal electrode 142 (referring to FIG. 1), since the first passivation layer 130 at the laser-treated region 191 has been completely etched, the conductive paste of the laser-treated region 191 does not need to penetrate through the first passivation layer 130 during a sintering process, so that the conductive paste can directly penetrate through the doped conductive layer 120 and the tunneling oxide layer 110 to be in direct contact with the substrate 100, which also cause the second metal electrode 142 (referring to FIG. 1) to be longer.

Referring to FIG. 11, , the method for laser processing a part of the first passivation layer 130 of the substrate 100 to form the laser-treated region 191 includes: laser etching the part of the first passivation layer 130 where the laser-treated region is to be formed by laser processing, and the laser-treated region to be formed includes: a first laser-treated region to be formed and a second laser-treated region to be formed, where the first laser-treated region to be formed is laser etched to expose a part of a surface of the doped conductive layer 120, and the second laser-treated region to be formed is laser etched to form a second passivation layer 131 with a preset thickness. That is, a part of the first passivation layer 130 corresponding to a part of the region to be laser-treated is completely etched away, and a part of the first passivation layer 130 corresponding to the remaining part of the region to be laser-treated is partially etched away, so that the first laser-treated region formed at the first laser-treated region to be formed is the exposed surface of the doped conductive layer 120, and the second laser-treated region formed at the second laser-treated region to be formed is the surface of the second passivation layer 131. When the conductive paste is printed on the laser-treated region 191, the conductive paste located in the first laser-treated region directly penetrates through the doped conductive layer 120 and the tunneling oxide layer 110, to be in contact with the substrate 100; the conductive paste located in the second laser-treated region further needs to penetrate the second passivation layer 131 with a predetermined thickness, the doped conductive layer 120 and the tunneling oxide layer 110. Therefore, referring to FIG. 11 and FIG. 1, in the substrate 100, the length of the second metal electrode 142 corresponding to the second laser-treated region is smaller than the length of the first metal electrode 141 corresponding to the first laser-treated region, so that in the direction from the tunnelling oxide layer 110 to the substrate 100, a shape that width of the second metal electrode 142 gradually decreases can be formed. By adjusting the degree of laser etching on the first passivation layer 130 by the laser process, the second passivation layer 131 with a preset thickness is formed, so as to adjust the length of the second metal electrode 142 in the substrate 100. In addition, laser etching is performed on the first passivation layer 130 in combination with different laser processes to form multiple laser-treated regions 191, so as to adjust the shape of the second metal electrode 142, so that the method for forming the second metal electrode 142 is simple and efficient.

Specifically, in some embodiments, a ratio of the thickness of the second passivation layer 131 to the thickness of the first passivation layer 130 ranges from 1:10 to 2:3, for example, 1:2. It can be understood that after the laser etching is performed on the first passivation layer 130, the remaining part of the first passivation layer 130 is served as the second passivation layer 131. Therefore, adjusting the ratio of the thickness of the second passivation layer 131 to the thickness of the first passivation layer 130 is the same as adjusting an etched thickness of the first passivation layer 130. The etched thickness of the first passivation layer 130 is adjusted, so that a distance from the surface of the second passivation layer 131 formed after laser etching to the first surface of the substrate 100 is changed. Therefore, after the conductive paste is subsequently printed on the surface of the second passivation layer 131, a distance that the conductive paste needs to penetrate during the sintering process will also be changed. It should be understood that, the smaller the distance from the second passivation layer 131 to the first surface of the substrate 100 is, the great the penetration depth of the conductive paste on the surface of the second passivation layer 131 into the substrate 100 is, so that the greater the length of the second metal electrode 142 in the substrate 100 is. Therefore, in a case that the laser-treated region 191 includes the surface of the second passivation layer 131 and the exposed surface of the doped conductive layer 120 the second metal electrode 142 formed in the laser-processed region 191 will have a shape that width of the second metal electrode 142 gradually decreases in the direction from the tunneling oxide layer 110 to the substrate 100. Based on the above considerations, the ratio of the thickness of the second passivation layer 131 to the thickness of the first passivation layer 130 is adjusted to be ranged from 1:10 to 2:3. On the one hand, the thickness of the second passivation layer 131 is not excessive, thereby ensuring that the conductive paste on the surface of the second passivation layer 131 can penetrate through the doped conductive layer 120 during sintering. On the other hand, the thickness of the second passivation layer 131 is not too small, so that in the direction from the tunnelling oxide layer 110 to the substrate 100, the shape that width of the second metal electrode 142 gradually decreases can be formed.

Referring to FIG. 1, FIG. 10 and FIG. 11, the conductive paste is printed on the laser-treated region 191 of the first surface and the region where the first metal electrode 141 is to be formed. The conductive paste includes first doping ions, which has the same type as the doping ions of the substrate 100. The first doping ions of the same type as the doping ions of the substrate 100 are added to the conductive paste. In this way, when the conductive paste is sintered, the first doping ions in the conductive paste are diffused from the conductive paste into the substrate 100, to form the local doped region 150 in the substrate 100, and the formed local doped region 150 covers the second metal electrode 142 located in the substrate 100. Specifically, by adjusting the concentration of the first doping ions in the conductive paste, the concentration of the first doping ions in the formed local doped region 150 can be adjusted, so that the concentration of the first doping ions in the local doped region 150 is greater than the concentration of the first doping ions in the substrate 100 to form a heavily doped region. The heavily doped region forms a high-low junction with the substrate 100, which on the one hand has a better interface passivation effect, so that the recombination of carriers can be reduced. On the other hand, an ohmic contact is formed between the local doped region 150 and the second metal electrode 142, to reduce the series resistance of the solar cell. In some embodiments, when the substrate 100 is an N-type semiconductor substrate 100, the first doping ions may be any one of phosphorus ions, arsenic ions, or antimony ions.

The conductive paste is sintered to form the second metal electrode 142 and the first metal electrode 141. Specifically, the second metal electrode 142 is formed by sintering the conductive paste in the laser-treated region 191, and the first metal electrode 141 is formed by sintering the conductive paste in the region where first metal electrode 141 is to be formed. In some embodiments, the conductive paste may be printed on the laser-treated region 191 of the first surface and the region where the first metal electrode 141 is to be formed by wire gauze printing, and then the conductive paste is sintered at a high temperature. For example, sintering at a peak temperature of 750°C to 850°C can be adopted to form the first metal electrode 141 and the second metal electrode 142. In some embodiments, in the conductive paste, the conductive material may be at least one of silver, aluminum, copper, tin, gold, lead, or nickel.

In some embodiments, the method for preparing a solar cell further includes: forming a third metal electrode 180 on the surface of the anti-reflection layer 170, and the third metal electrode 180 penetrates through the anti-reflection layer 170 to form an electrical connection with the emitter 160. The method for forming the third metal electrode 180 includes: performing a metallization process on the surface of the anti-reflection layer 170, where the metallization process includes the wire gauze printing process and the high temperature sintering process, to form the third metal electrode 180 being electrically connected to the emitter 160.

In the method for preparing a solar cell provided according to the above embodiments, the first metal electrode 141 is formed to penetrate through the first passivation layer 130 to be electrically connected to the doped conductive layer 120, and the second metal electrode 142 penetrates through the tunnelling oxide layer 110 to be in contact with the substrate 100, so that the transport of carriers done by the second metal electrode 142 is not limited by the tunneling oxide layer 110, which has a higher transport efficiency. In addition, the first metal electrode 141 does not penetrate through the tunneling oxide layer 110, so that the tunneling oxide layer 110 maintains a better passivation effect. The local doped region 150 configured to be cover second metal electrode 142 is further formed in the substrate 100. The doping concentration of the local doped region 150 is greater than the doping concentration of the substrate 100, to form a high and low junction with the substrate 100, so that the local doped region 150 has a passivation effect on the interface between the second metal electrode 142 and the substrate 100, which can reduce the recombination of carriers at the interface, and further enhance the capability for transporting the carriers, so as to reduce the series resistance of the solar cell.

Although the present disclosure is disclosed above with preferred embodiments, it is not used to limit the claims. The scope of protection shall be subject to the scope defined by the claims of the present disclosure.

Those of ordinary skill in the art can understand that the above embodiments are specific examples for implementing the present disclosure. In practice, various changes can be made in form and details without departing from the scope of the present disclosure. Any person skilled in the art can make changes and amendments without departing from the scope of the present disclosure. Therefore, the protection scope of the present disclosure should be subject to the scope defined by the claims.

## Claims

1. A solar cell (101), comprising:
a substrate (100), having a first surface;
a tunnelling oxide layer (110), a doped conductive layer (120) and a first passivation layer (130) that are provided on the first surface sequentially in a direction away from the substrate (100);
a first metal electrode (141) and a second metal electrode (142), wherein the first metal electrode (141) penetrates through the first passivation layer (130) to be electrically connected to the doped conductive layer (120), and the first metal electrode (141) does not penetrate through the tunnelling oxide layer (110); the second metal electrode (142) is connected to a surface of the first metal electrode (141) facing toward the substrate (100), the second metal electrode (142) penetrates through the tunnelling oxide layer (110) to be in contact with the substrate (100), and a width of the second metal electrode (142) is smaller than a width of the first metal electrode (141); and
a local doped region (150), wherein the local doped region (150) is located in the substrate (100), and covers the second metal electrode (142) located in the substrate (100); the local doped region (150) and the substrate (100) have doping elements of a same conductivity type, and a doping concentration of the local doped region (150) is greater than a doping concentration of the substrate (100);
the solar cell (101) is **characterized in that**,
the second metal electrode (142) consists of a plurality of sub-electrodes provided in a spaced manner, and in a direction from the tunnelling oxide layer (110) to the substrate (100), the plurality of sub-electrodes gradually decrease in width; and
in the direction from the tunneling oxide layer (110) to the substrate (100), the plurality of sub-electrodes located in the tunneling oxide layer (110) gradually decrease in cross-sectional area.

2. The solar cell according to claim 1, wherein a ratio of a contact area between the second metal electrode (142) and the first metal electrode (141) to a cross-sectional area of the first metal electrode (141) ranges from 1:16 to 2:3.

3. The solar cell according to claim 1, wherein in the direction from the tunnelling oxide layer (110) to the substrate (100), a ratio of a length of a part of the second metal electrode (142) located in the substrate (100) to a total length of the second metal electrode (142) ranges from 1:10 to 9:10.

4. The solar cell according to claim 1, wherein a ratio of the doping concentration of the local doped region (150) to the doping concentration of the substrate (100) ranges from 10000:1 to 200000:1.

5. The solar cell according to claim 4, wherein the doping concentration of the local doped region (150) ranges from 1x10²⁰ atoms/cm³ to 2x10²¹ atoms/cm³.

6. A photovoltaic module, comprising:
a cell string, wherein the cell string is formed by connecting a plurality of solar cells (101) with each other, each of the plurality of solar cells (101) being a solar cell (101) according to any one of claims 1 to 5;
a package layer (102) configured to cover a surface of the cell string;
a cover plate (103) configured to cover a surface of the package layer (102) away from the cell string.

7. A method for preparing a solar cell, comprising:
providing a substrate (100);
forming a tunnelling oxide layer (110), a doped conductive layer (120) and a first passivation layer (130) sequentially on a first surface of the substrate (100) in a direction away from the substrate (100);
forming a first metal electrode (141) and a second metal electrode (142), wherein the first metal electrode (141) penetrates through the first passivation layer (130) to be electrically connected to the doped conductive layer (120), and the first metal electrode (141) does not penetrate through the tunnelling oxide layer (110); the second metal electrode (142) is connected to a surface of the first metal electrode (141) facing toward the substrate (100), the second metal electrode (142) penetrates through the tunnelling oxide layer (110) to be in contact with the substrate (100), and a width of the second metal electrode (142) is smaller than a width of the first metal electrode (141); and
forming a local doped region (150) in the substrate, wherein the local doped region (150) is located in the substrate (100), and covers the second metal electrode (142) located in the substrate (100); the local doped region (150) and the substrate (100) have doping elements of a same conductivity type, and a doping concentration of the local doped region (150) is greater than a doping concentration of the substrate (100);
wherein the forming the first metal electrode (141) and the second metal electrode (142) comprises:
laser processing a part of the first passivation layer (130) of the substrate (100) to form a laser-treated region, wherein the laser-treated region corresponds to a region where the second metal electrode (142) is to be formed; in the first passivation layer (130), a region other than the laser-treated region is defined as a flat region, the flat region comprises a region where the first metal electrode (141) is to be formed, and the laser-treated region is located in region where the second metal electrode (142) is to be formed;
printing a conductive paste on the laser-treated region and on the region where the first metal electrode (141) is to be formed, wherein the conductive paste comprises a first doping ion, and the first doping ion has a same type with a doping ion of the substrate (100); and
sintering the conductive paste to form the second metal electrode (142) and the first metal electrode (141);
wherein the laser processing the part of the first passivation layer (130) of the substrate (100) to form the laser-treated region comprises:
laser etching the part of the first passivation layer (130) where the laser-treated region is to be formed by laser processing, and the laser-treated region to be formed comprises: a first laser-treated region to be formed and a second laser-treated region to be formed, wherein the first laser-treated region to be formed is laser etched to expose a part of a surface of the doped conductive layer, and the second laser-treated region to be formed is laser etched to form a second passivation layer (131) with a preset thickness
**characterized in that**,
the second metal electrode (142) consists of a plurality of sub-electrodes provided in a spaced manner, and in a direction from the tunnelling oxide layer (110) to the substrate (100), the plurality of sub-electrodes gradually decrease in width; and
in the direction from the tunneling oxide layer (110) to the substrate (100), the plurality of sub-electrodes located in the tunneling oxide layer (110) gradually decrease in cross-sectional area.

8. The method for preparing a solar cell according to claim 7, wherein a ratio of a thickness of the second passivation layer (131) to a thickness of the first passivation layer ranges (130) from 1:10 to 2:3.

9. The method for preparing a solar cell according to claim 8, further comprising:
forming an emitter (160) on a second surface of the substrate (100) opposite to the first surface;
forming an anti-reflection layer (170) on the second surface; and
forming a third metal electrode (180) on the second surface of the substrate (100), wherein the third metal electrode (180) penetrates through the anti-reflection layer (170) to be electrically connected to the emitter (160).

## Patentansprüche

1. Solarzelle (101), umfassend:
ein Substrat (100), das eine erste Oberfläche aufweist;
eine Tunneloxidschicht (110), eine dotierte leitfähige Schicht (120) und eine erste Passivierungsschicht (130), die auf der ersten Oberfläche aufeinanderfolgend in einer Richtung weg von dem Substrat (100) bereitgestellt sind;
eine erste Metallelektrode (141) und eine zweite Metallelektrode (142), wobei die erste Metallelektrode (141) derart durch die erste Passivierungsschicht (130) eindringt, dass sie elektrisch mit der dotierten leitfähigen Schicht (120) verbunden ist, und die erste Metallelektrode (141) nicht durch die Tunneloxidschicht (110) eindringt; wobei die zweite Metallelektrode (142) mit einer Oberfläche der ersten Metallelektrode (141) verbunden ist, die dem Substrat (100) zugewandt ist, die zweite Metallelektrode (142) derart durch die Tunneloxidschicht (110) eindringt, dass sie mit dem Substrat (100) in Kontakt ist, und eine Breite der zweiten Metallelektrode (142) kleiner als eine Breite der ersten Metallelektrode (141) ist; und
eine lokale dotierte Region (150), wobei die lokale dotierte Region (150) sich in dem Substrat (100) befindet und die zweite Metallelektrode (142) bedeckt, die sich in dem Substrat (100) befindet; die lokale dotierte Region (150) und das Substrat (100) Dotierungselemente eines gleichen Leitfähigkeitstyps aufweisen und eine Dotierungskonzentration der lokalen dotierten Region (150) größer als eine Dotierungskonzentration des Substrats (100) ist;
die Solarzelle (101) **dadurch gekennzeichnet ist, dass**
die zweite Metallelektrode (142) aus einer Vielzahl von Unterelektroden besteht, die auf eine beabstandete Weise bereitgestellt sind, und die Breite der Vielzahl von Unterelektroden in einer Richtung von der Tunneloxidschicht (110) zum Substrat (100) allmählich abnimmt; und
in der Richtung von der Tunneloxidschicht (110) zu dem Substrat (100) die Querschnittsfläche der Vielzahl von Unterelektroden, die sich in der Tunneloxidschicht (110) befinden, allmählich abnimmt.

2. Solarzelle nach Anspruch 1, wobei ein Verhältnis einer Kontaktfläche zwischen der zweiten Metallelektrode (142) und der ersten Metallelektrode (141) zu einer Querschnittsfläche der ersten Metallelektrode (141) in einem Bereich von 1:16 bis 2:3 liegt.

3. Solarzelle nach Anspruch 1, wobei in der Richtung von der Tunneloxidschicht (110) zu dem Substrat (100) ein Verhältnis einer Länge eines Teils der zweiten Metallelektrode (142), die sich in dem Substrat (100) befindet, zu einer Gesamtlänge der zweiten Metallelektrode (142) in einem Bereich von 1:10 bis 9:10 liegt.

4. Solarzelle nach Anspruch 1, wobei ein Verhältnis der Dotierungskonzentration der lokalen dotierten Region (150) zur Dotierungskonzentration des Substrats (100) in einem Bereich von 10000:1 bis 200000:1 liegt.

5. Solarzelle nach Anspruch 4, wobei die Dotierungskonzentration der lokalen dotierten Region (150) in einem Bereich von 1x10²⁰ Atomen/cm³ bis 2x10²¹ Atomen/cm³ liegt.

6. Photovoltaikmodul, umfassend:
einen Zellenstrang, wobei der Zellenstrang durch Verbinden einer Vielzahl von Solarzellen (101) miteinander gebildet ist, wobei jede der Vielzahl von Solarzellen (101) eine Solarzelle (101) nach einem der Ansprüche 1 bis 5 ist;
eine Gehäuseschicht (102), die dazu ausgestaltet ist, eine Oberfläche des Zellenstrangs zu bedecken;
eine Abdeckplatte (103), die dazu ausgestaltet ist, eine Oberfläche der Gehäuseschicht (102), die von dem Zellenstrang abgewandt ist, zu bedecken.

7. Verfahren zum Herstellen einer Solarzelle, umfassend:
Bereitstellen eines Substrats (100);
Bilden einer Tunneloxidschicht (110), einer dotierten leitfähigen Schicht (120) und einer ersten Passivierungsschicht (130) aufeinanderfolgend auf einer ersten Oberfläche des Substrats (100) in einer Richtung weg von dem Substrat (100);
Bilden einer ersten Metallelektrode (141) und einer zweiten Metallelektrode (142), wobei die erste Metallelektrode (141) derart durch die erste Passivierungsschicht (130) eindringt, dass sie elektrisch mit der dotierten leitfähigen Schicht (120) verbunden wird, und die erste Metallelektrode (141) nicht durch die Tunneloxidschicht (110) eindringt; die zweite Metallelektrode (142) mit einer Oberfläche der ersten Metallelektrode (141) verbunden wird, die dem Substrat (100) zugewandt ist, die zweite Metallelektrode (142) derart durch die Tunneloxidschicht (110) eindringt, dass sie mit dem Substrat (100) in Kontakt gelangt, und eine Breite der zweiten Metallelektrode (142) kleiner als eine Breite der ersten Metallelektrode (141) ist; und
Bilden einer lokalen dotierten Region (150) in dem Substrat, wobei die lokale dotierte Region (150) sich in dem Substrat (100) befindet und die zweite Metallelektrode (142) bedeckt, die sich in dem Substrat (100) befindet; wobei die lokale dotierte Region (150) und das Substrat (100) Dotierungselemente mit einem gleichen Leitfähigkeitstyp aufweisen und eine Dotierungskonzentration der lokalen dotierten Region (150) größer als eine Dotierungskonzentration des Substrats (100) ist;
wobei das Bilden der ersten Metallelektrode (141) und der zweiten Metallelektrode (142) umfasst:
Laserbearbeiten eines Teils der ersten Passivierungsschicht (130) des Substrats (100), um eine laserbehandelte Region zu bilden, wobei die laserbehandelte Region einer Region entspricht, wo die zweite Metallelektrode (142) zu bilden ist; in der ersten Passivierungsschicht (130) eine Region, die sich von der laserbehandelten Region unterscheidet, als eine flache Region definiert wird, wobei die flache Region eine Region umfasst, wo die erste Metallelektrode (141) zu bilden ist, und die laserbehandelte Region sich in einer Region befindet, wo die zweite Metallelektrode (142) zu bilden ist;
Drucken einer leitfähigen Paste auf der laserbehandelten Region und auf der Region, wo die erste Metallelektrode (141) zu bilden ist, wobei die leitfähige Paste ein erstes Dotierungsion umfasst und das erste Dotierungsion einen gleichen Typ mit einem Dotierungsion des ersten Substrats (100) aufweist; und
Sintern der leitfähigen Paste, um die zweite Metallelektrode (142) und die erste Metallelektrode (141) zu bilden;
wobei das Laserbearbeiten des Teils der ersten Passivierungsschicht (130) des Substrats (100), um die laserbehandelte Region zu bilden, umfasst:
Laserätzen des Teils der ersten Passivierungsschicht (130), wo die laserbehandelte Region durch Laserbearbeitung zu bilden ist, und die laserbehandelte Region, die zu bilden ist, umfasst: eine erste laserbehandelte Region, die zu bilden ist, und eine zweite laserbehandelte Region, die zu bilden ist, wobei die erste laserbehandelte Region, die zu bilden ist, lasergeätzt wird, um einen Teil einer Oberfläche der dotierten leitfähigen Schicht freizulegen, und die zweite laserbehandelte Region, die zu bilden ist, lasergeätzt wird, um eine zweite Passivierungsschicht (131) mit einer voreingestellten Dicke zu bilden;
**dadurch gekennzeichnet, dass**
die zweite Metallelektrode (142) aus einer Vielzahl von Unterelektroden besteht, die auf eine beabstandete Weise bereitgestellt werden, und in einer Richtung von der Tunneloxidschicht (110) zum Substrat (100) die Breite der Vielzahl von Unterelektroden allmählich abnimmt; und
in der Richtung von der Tunneloxidschicht (110) zum Substrat (100) die Querschnittsfläche der Vielzahl von Unterelektroden, die sich in der Tunneloxidschicht (110) befinden, allmählich abnimmt.

8. Verfahren zum Herstellen einer Solarzelle nach Anspruch **7,** wobei ein Verhältnis einer Dicke der zweiten Passivierungsschicht (131) zu einer Dicke der ersten Passivierungsschicht (130) in einem Bereich von 1:10 bis 2:3 liegt.

9. Verfahren zum Herstellen einer Solarzelle nach Anspruch 8, ferner umfassend:
Bilden eines Emitters (160) auf einer zweiten Oberfläche des Substrats (100), die der ersten Oberfläche entgegengesetzt ist;
Bilden einer Antireflexionsschicht (170) auf der zweiten Oberfläche; und
Bilden einer dritten Metallelektrode (180) auf der zweiten Oberfläche des Substrats (100), wobei die dritte Metallelektrode (180) derart durch die Antireflexionsschicht (170) eindringt, dass sie elektrisch mit dem Emitter (160) verbunden wird.

## Revendications

1. Cellule solaire (101) comprenant :
un substrat (100) ayant une première surface ;
une couche d'oxyde à effet tunnel (110), une couche conductrice dopée (120) et une première couche de passivation (130) qui sont disposées sur la première surface en séquence dans une direction s'éloignant du substrat (100) ;
une première électrode métallique (141) et une deuxième électrode métallique (142), parmi lesquelles la première électrode métallique (141) pénètre à travers la première couche de passivation (130) pour être électriquement connectée à la couche conductrice dopée (120), et la première électrode métallique (141) ne pénètre pas à travers la couche d'oxyde à effet tunnel (110) ; la deuxième électrode métallique (142) est connectée à une surface de la première électrode métallique (141) orientée vers le substrat (100), la deuxième électrode métallique (142) pénètre à travers la couche d'oxyde à effet tunnel (110) pour être en contact avec le substrat (100), la largeur de la deuxième électrode métallique (142) étant inférieure à la largeur de la première électrode métallique (141) ; et
une région dopée locale (150), laquelle région dopée locale (150) est située dans le substrat (100) et couvre la deuxième électrode métallique (142) située dans le substrat (100) ; la région dopée locale (150) et le substrat (100) ayant des éléments dopants d'un même type de conductivité, et la concentration de dopage de la région dopée locale (150) étant supérieure à la concentration de dopage du substrat (100) ;
laquelle cellule solaire (101) est **caractérisée en ce que**
la deuxième électrode métallique (142) consiste en une pluralité de sous-électrodes disposées d'une manière espacée et, dans la direction allant de la couche d'oxyde à effet tunnel (110) au substrat (100), la largeur de la pluralité de sous-électrodes diminue progressivement ; et
dans la direction allant de la couche d'oxyde à effet tunnel (110) au substrat (100), la superficie en coupe transversale de la pluralité de sous-électrodes situées dans la couche d'oxyde à effet tunnel (110) diminue progressivement.

2. Cellule solaire selon la revendication 1, dans laquelle le rapport de la superficie de contact entre la deuxième électrode métallique (142) et la première électrode métallique (141) à la superficie en coupe transversale de la première électrode métallique (141) est situé dans la plage allant de 1 :16 à 2 :3.

3. Cellule solaire selon la revendication 1, dans laquelle, dans la direction allant de la couche d'oxyde à effet tunnel (110) au substrat (100), le rapport de la longueur d'une partie de la deuxième électrode métallique (142) située dans le substrat (100) à la longueur totale de la deuxième électrode métallique (142) est situé dans la plage allant de 1 :10 à 9 :10.

4. Cellule solaire selon la revendication 1, dans laquelle le rapport de la concentration de dopage de la région dopée locale (150) à la concentration de dopage du substrat (100) est situé dans la plage allant de 10000 :1 à 200000 : 1.

5. Cellule solaire selon la revendication 4, dans laquelle la concentration de dopage de la région dopée locale (150) est située dans la plage allant de 1 x 10²⁰ atomes/cm³ à 2 x 10²¹ atomes/cm³.

6. Module photovoltaïque comprenant :
une chaîne de cellules, laquelle chaîne de cellules est formée par connexion d'une pluralité de cellules solaires (101) les unes aux autres, chacune parmi la pluralité de cellules solaires (101) étant une cellule solaire (101) selon l'une quelconque des revendications 1 à 5 ;
une couche d'encapsulation (102) configurée pour recouvrir une surface de la chaîne de cellules ;
une plaque de recouvrement (103) configurée pour recouvrir une surface de la couche d'encapsulation (102) opposée à la chaîne de cellules.

7. Procédé pour préparer une cellule solaire, comprenant :
la fourniture d'un substrat (100) ;
la formation d'une couche d'oxyde à effet tunnel (110), d'une couche conductrice dopée (120) et d'une première couche de passivation (130) en séquence sur une première surface du substrat (100) dans une direction s'éloignant du substrat (100) ;
la formation d'une première électrode métallique (141) et d'une deuxième électrode métallique (142), dans laquelle la première électrode métallique (141) pénètre à travers la première couche de passivation (130) pour être électriquement connectée à la couche conductrice dopée (120), et la première électrode métallique (141) ne pénètre pas à travers la couche d'oxyde à effet tunnel (110) ; la deuxième électrode métallique (142) est connectée à une surface de la première électrode métallique (141) orientée vers le substrat (100), la deuxième électrode métallique (142) pénètre à travers la couche d'oxyde à effet tunnel (110) pour être en contact avec le substrat (100), et la largeur de la deuxième électrode métallique (142) est inférieure à la largeur de la première électrode métallique (141) ; et
la formation d'une région dopée locale (150) dans le substrat, dans laquelle la région dopée locale (150) est située dans le substrat (100) et couvre la deuxième électrode métallique (142) située dans le substrat (100) ; la région dopée locale (150) et le substrat (100) ont des éléments dopants d'un même type de conductivité, et la concentration de dopage de la région dopée locale (150) est supérieure à la concentration de dopage du substrat (100) ;
dans lequel la formation de la première électrode métallique (141) et de la deuxième électrode métallique (142) comprend :
le traitement au laser d'une partie de la première couche de passivation (130) du substrat (100) pour former une région traitée au laser, dans lequel la région traitée au laser correspond à une région où la deuxième électrode métallique (142) doit être formée ; dans la première couche de passivation (130), une région autre que la région traitée au laser est définie comme étant une région plate, la région plate comprend une région où la première électrode métallique (141) doit être formée, et la région traitée au laser est située dans une région où la deuxième électrode métallique (142) doit être formée ;
l'impression d'une pâte conductrice sur la région traitée au laser et sur la région où la première électrode métallique (141) doit être formée, dans laquelle la pâte conductrice comprend un premier ion dopant, et le premier ion dopant est du même type qu'un ion dopant du substrat (100) ; et
le frittage de la pâte conductrice pour former la deuxième électrode métallique (142) et la première électrode métallique (141) ;
dans lequel le traitement au laser de la partie de la première couche de passivation (130) du substrat (100) pour former la région traitée au laser comprend :
la gravure au laser de la partie de la première couche de passivation (130) où la région traitée au laser doit être formée par traitement au laser, et la région traitée au laser devant être formée comprend : une première région traitée au laser devant être formée et une deuxième région traitée au laser devant être formée, dans laquelle la première région traitée au laser devant être formée est gravée au laser pour que soit exposée une partie d'une surface de la couche conductrice dopée, et la deuxième région traitée au laser devant être formée est gravée au laser pour former une deuxième couche de passivation (131) ayant une épaisseur prédéterminée,
**caractérisé en ce que**
la deuxième électrode métallique (142) consiste en une pluralité de sous-électrodes disposées d'une manière espacée et, dans la direction allant de la couche d'oxyde à effet tunnel (110) au substrat (100), la largeur de la pluralité de sous-électrode diminue progressivement ; et
dans la direction allant de la couche d'oxyde à effet tunnel (110) au substrat (100), la superficie en coupe transversale de la pluralité de sous-électrodes situées dans la couche d'oxyde à effet tunnel (110) diminue progressivement.

8. Procédé pour préparer une cellule solaire selon la revendication 7, dans lequel le rapport de l'épaisseur de la deuxième couche de passivation (131) à l'épaisseur de la première couche de passivation (130) est situé dans la plage allant de 1 :10 à 2 :3.

9. Procédé pour préparer une cellule solaire selon la revendication 8, comprenant en outre :
la formation d'un émetteur (160) sur une deuxième surface du substrat (100) opposée à la première surface ;
la formation d'une couche antireflet (170) sur la deuxième surface ; et
la formation d'une troisième électrode métallique (180) sur la deuxième surface du substrat (100), dans laquelle la troisième électrode métallique (180) pénètre à travers la couche antireflet (170) pour être électriquement connectée à l'émetteur (160) .
